Europäisches Patentamt

European Patent Office

Office européen des brevets

(19)

(11) **EP 1 152 526 B1**

(12) **FASCICULE DE BREVET EUROPEEN**

(45) Date de publication et mention
de la délivrance du brevet:
**26.11.2003 Bulletin 2003/48**

(51) Int Cl.⁷: **H03G 3/20**

(21) Numéro de dépôt: **01400957.5**

(22) Date de dépôt: **13.04.2001**

(54) **Synthonisateur du type à fréquence intermédiaire nulle et procédé de commande correspondant**

Null-ZF-Tuner und Verfahren für dessen Kontrolle

Zero-if tuner and corresponding control method

(84) Etats contractants désignés:
**DE FR GB IT**

(30) Priorité: **21.04.2000 FR 0005142**

(43) Date de publication de la demande:
**07.11.2001 Bulletin 2001/45**

(73) Titulaire: **STMicroelectronics S.A.**
**92120 Montrouge (FR)**

(72) Inventeurs:
 • **Busson, Pierre**
  **38000 Grenoble (FR)**
 • **Jouffre, Pierre-Olivier**
  **38000 Grenoble (FR)**
 • **Paillardet, Frédéric**
  **73100 Aix-les-Bains (FR)**

(74) Mandataire: **Dossmann, Gérard**
  **Bureau D.A. Casalonga-Josse**
  **Paul-Heyse-Strasse 33**
  **80336 München (DE)**

(56) Documents cités:
  **EP-A- 0 413 311**          **EP-A- 0 657 997**

**Description**

L'invention concerne le décodage d'un canal de transmission radiofréquence véhiculant des informations numériques codées. Elle s'applique avantageusement mais non limitativement à la télédiffusion numérique par satellite telle que définie dans la spécification européenne DVB-S (Digital Video Broadcasting-satellite) basée sur les normes de compression MPEG, et utilisant par exemple pour véhiculer les informations, une modulation numérique en quadrature. L'invention concerne ainsi plus particulièrement les synthonisateurs ("tuner" en langue anglaise), en particulier du type à fréquence intermédiaire nulle, tels que par exemple ceux incorporés dans les récepteurs-satellite avec décodeurs de données d'images comprimées ("Set-top box" en langue anglaise).

Les signaux de télévision en provenance d'un satellite sont amplifiés et convertis dans une bande de fréquences prédéterminée (typiquement 950-2150 MHz) par l'intermédiaire d'une parabole et d'un convertisseur à faible bruit situé au foyer de la parabole.

Ce signal est ensuite envoyé à l'entrée du synthonisateur du récepteur. Le synthonisateur a pour but de sélectionner le canal désiré et de sortir un signal en bande de base sur la voie en phase (voie I) et sur la voie en quadrature (voie Q). Ce signal est ensuite converti en un signal numérique et démodulé. Les traitements de décodage de canal comportent ensuite également un bloc qui distingue, typiquement au moyen d'une logique majoritaire les zéros des uns, puis effectuent l'ensemble de la correction d'erreur, c'est-à-dire typiquement un décodage de Viterbi, le désentrelacement, un décodage de Reed-Solomon et le débrassage. Le dispositif de décodage de canal fournit en sortie des paquets qui sont décodés de façon classique dans un dispositif de décodage de source conforme aux normes MPEG de façon à redélivrer en sortie les signaux audio et vidéo initiaux transmis via le satellite.

A l'entrée du récepteur, le signal reçu est composé de l'ensemble des canaux émis pour le satellite et transposés dans la bande de fréquence 950-2150 MHz. La puissance globale reçue est sensiblement égale à la puissance moyenne sur un canal augmentée de dix fois le logarithme népérien du nombre des canaux. Ce signal possède une variation importante, de l'ordre de 50 dBm.

Actuellement, dans l'ensemble des récepteurs, le signal reçu en entrée est normalement filtré par un filtre de type large bande (dont la bande passante est de l'ordre de plusieurs centaines de MHz) disposé juste après l'amplificateur d'entrée faible bruit, et ce afin d'éviter la saturation des étages suivants du synthonisateur (notamment les étages d'amplification à gain commandé ainsi que les mélangeurs de l'étage de transposition de fréquence). Par ailleurs, les solutions actuelles prévoient de réaliser à l'extérieur de la puce contenant l'étage d'amplification à gain commandé ainsi que l'étage de transposition de fréquence, l'amplificateur d'entrée à faible bruit ainsi que les filtres large bande. Ces filtres, dont les fréquences de coupure sont ajustables par la sélection du canal désirée, sont alors réalisés par des composants discrets tels que des diodes "varicap".

Or, de tels composants présentent une taille trop importante incompatible avec une réalisation totalement intégrée du synthonisateur.

L'invention vise à apporter une solution à ce problème.

Un but de l'invention est de proposer un synthonisateur totalement réalisable de façon intégrée sur le substrat de silicium, et ce, tout en évitant la saturation des différents éléments du synthonisateur.

L'invention propose donc un procédé de commande d'un synthonisateur du type à fréquence intermédiaire nulle, comprenant un bloc analogique comportant un premier étage atténuateur/amplificateur à gain commandé connecté en amont d'un étage de transposition de fréquence comportant des moyens de filtrage en bande de base, et un bloc numérique connecté au bloc analogique par un étage de conversion analogique/numérique.

Selon une caractéristique générale de l'invention, le procédé de commande comprend une phase d'initialisation dans laquelle on calcule la puissance globale moyenne de l'intégralité du signal reçu par le synthonisateur, on compare dans le bloc numérique cette puissance globale calculée avec une première valeur de référence prédéterminée correspondant à une puissance maximale souhaitée en un endroit prédéterminé du bloc analogique, par exemple à l'entrée des mélangeurs de l'étage de transposition de fréquence. On règle alors le gain du premier étage atténuateur/amplificateur jusqu'à minimiser l'écart entre la puissance globale calculée et la valeur de référence.

Le procédé de commande selon l'invention comporte par ailleurs une phase de fonctionnement normal dans laquelle, le gain du premier étage atténuateur/modificateur étant figé, on sélectionne l'un des canaux du signal reçu.

D'une façon générale, on peut calculer la puissance globale moyenne de l'intégralité du signal reçu par le synthonisateur à partir de tout signal disponible dans le bloc analogique en amont du premier filtre de ce bloc analogique. Ainsi, lorsque les mélangeurs de l'étage de transposition de fréquence ne sont pas équipés de filtres, le premier filtre rencontré dans le bloc analogique est le filtre bande de base. On pourra donc dans ce cas utiliser tout signal pris en amont de ce filtre bande de base. Ceci étant, généralement les mélangeurs utilisés dans un étage de transposition de fréquence d'un synthonisateur comportent intrinsèquement un filtre. Dans ce cas, une analyse de la puissance globale du signal reçu est réalisée avant les mélangeurs, ces éléments étant les derniers de la chaîne de réception analogique recevant l'ensemble de la puissance de différents canaux. Ceci étant, il est préférable, en particulier pour des raisons de conception du circuit intégré, d'utiliser le signal disponible entre la sortie du premier étage atténuateur/amplificateur et l'entrée de l'étage de transposition de fréquence.

Selon une mise en oeuvre du procédé selon l'invention, le calcul de la puissance globale moyenne de l'intégralité du signal reçu est effectué dans le bloc numérique, c'est-à-dire en aval de l'étage de conversion analogique/numérique. Ce calcul de la puissance globale moyenne comporte alors par exemple un calcul du module du signal échantillonné ainsi qu'une intégration numérique sur un certain nombre d'échantillons, typiquement $2^{21}$. Ceci étant, il serait possible en variante de prévoir un filtre analogique intégrateur dans le bloc analogique destiné à effectuer la moyenne du signal analogique à partir duquel on souhaite calculer la puissance globale moyenne. Puis, le signal de sortie du filtre (tension), représentatif de la puissance moyenne globale du signal reçu, serait alors échantillonné dans l'étage de conversion analogique/numérique. En théorie, il ne serait alors nécessaire d'utiliser qu'un seul échantillon pour effectuer la comparaison avec la valeur de référence. Mais, en pratique, on effectuerait cette comparaison avec une valeur moyenne calculée sur un nombre très limité d'échantillons, par exemple trois ou quatre.

Le procédé selon l'invention est également particulièrement avantageux lorsque le bloc analogique du synthonisateur comporte en outre un deuxième étage amplificateur à gain commandé connecté en aval des moyens de filtrage. en bande de base. Dans ce cas, selon un mode de mise en oeuvre du procédé, on calcule, dans la phase de fonctionnement normal, la puissance moyenne du canal sélectionné, on compare dans le bloc numérique cette puissance moyenne du canal calculée avec une deuxième valeur de référence prédéterminée correspondant à une puissance de canal maximale souhaitée à l'entrée de l'étage de conversion analogique/numérique et on règle le gain du deuxième étage amplificateur jusqu'à minimiser l'écart entre la puissance de canal calculée et ladite deuxième valeur de référence.

En d'autres termes, après la phase d'initialisation, le signal est commuté vers les mélangeurs de l'étage de transposition de fréquence, et le deuxième étage d'amplification à gain commandé, intégré au filtre de bande de base, permet de régler de façon fine le niveau à l'entrée du convertisseur de façon à avoir une puissance correspondant au maximum de dynamique de l'étage de conversion analogique/numérique.

Le fait, selon l'invention, de calculer dans une phase d'initialisation la puissance globale du signal reçu et de régler le gain du premier étage atténuateur/amplificateur à gain commandé, puis d'ajuster le gain du deuxième étage amplificateur dans la phase de fonctionnement normal, permet un meilleur équilibrage entre la commande des gains des deux étages amplificateurs à gain commandé.

En effet, dans les solutions de l'art antérieur, prévoyant des filtres externes de type large bande, à composants discrets, commandables en fonction de la sélection du canal désirée, il n'y a pas de phase d'initialisation dans laquelle on calcule la puissance globale de l'intégralité du signal reçu. La puissance du signal est en effet calculée à la sortie du bloc analogique, après conversion analogique/numérique, sur un signal filtré comportant outre le canal sélectionné, les canaux immédiatement adjacents. Et, c'est à partir de ce seul calcul de puissance que l'on règle les gains des différents étages d'amplification à gain commandé. Or, l'inconvénient de cette solution réside dans le fait que l'on ne possède alors qu'une seule source d'information concernant la puissance de réception sur le synthonisateur et que cette information est située à la sortie de la chaîne analogique. Et, cette information est déjà filtrée et ne possède donc qu'une partie du signal d'entrée, à savoir le canal désiré et éventuellement les canaux adjacents. La précision de réglage des différents amplificateurs à gain commandé est donc moins précise que celle utilisée dans la présente invention qui utilise deux calculs de puissance différents, dans la phase d'initialisation et dans la phase de fonctionnement normal, pour régler de façon indépendante les gains des deux étages d'amplification à gain commandé.

En outre, si l'on suppose maintenant qu'un pic de réception parasite se situe au voisinage du canal sélectionné, celui-ci va influer fortement dans le calcul de la puissance effectuée en bout de chaîne analogique dans les solutions de l'art antérieur. En conséquence, le gain du premier étage amplificateur va avoir tendance à être minimisé pour éviter une saturation des éléments suivants, ce qui va conduire à une augmentation du gain du deuxième étage amplificateur de façon à obtenir le maximum de dynamique à l'entrée de l'étage de conversion analogique/numérique.

Par contre, dans le procédé selon l'invention, la puissance du pic parasite est "diluée" dans la puissance globale du signal reçu. Ceci va conduire, dans la phase d'initialisation, à régler le premier étage amplificateur avec un gain un peu plus élevé que dans l'art antérieur. De ce fait, dans la phase de fonctionnement normal, le calcul de la puissance de canal effectué en sortie de la chaîne analogique va conduire à régler le gain du deuxième étage amplificateur avec un gain plus faible que dans l'art antérieur. On obtient donc une plus grande marge de manoeuvre sur le réglage de gain du deuxième amplificateur et également un meilleur équilibrage dans la commande des gains.

L'invention a également pour objet un dispositif de synthonisation du type à fréquence intermédiaire nulle, comprenant une entrée de signal, un bloc analogique comportant un premier étage atténuateur/amplificateur à gain commandé connecté entre l'entrée de signal et un étage de transposition de fréquence comportant des moyens de filtrage en bande de base, et un bloc numérique connecté au bloc analogique par un étage de conversion analogique/numérique.

Selon une caractéristique générale de l'invention, le dispositif comprend :

- un moyen commandable d'aiguillage de signal, incorporé dans le bloc analogique, possédant une borne d'entrée connectée à l'entrée de signal, une première borne de sortie connectée à l'entrée des moyens de filtrage en bande de base, une deuxième borne de sortie connectée directement à l'entrée de l'étage de conversion analogique/ numérique,

- des premiers moyens de calcul, connectés à la deuxième borne de sortie du moyen d'aiguillage, aptes à calculer la puissance globale moyenne de l'intégralité du signal reçu par le synthonisateur,
- des premiers moyens de comparaison, incorporés dans le bloc numérique, aptes à comparer cette puissance globale calculée avec une première valeur de référence prédéterminée correspondant à une puissance maximale souhaitée en un endroit prédéterminé du bloc analogique,
- des premiers moyens de réglage aptes à régler le gain du premier étage atténuateur/amplificateur en fonction du résultat de ladite comparaison, et
- des moyens de commande aptes dans une phase d'initialisation, à commander les moyens d'aiguillage de façon à relier leur borne d'entrée et leur deuxième borne de sortie, jusqu'à minimiser l'écart entre la puissance globale calculée et ladite première valeur de référence, et dans une phase de fonctionnement normal au cours de laquelle un canal du signal reçu est sélectionné, à commander les moyens d'aiguillage de façon à relier leur borne d'entrée et leur première borne de sortie, le gain du premier étage atténuateur/amplificateur étant figé.

Selon un mode de réalisation du dispositif, le bloc analogique du synthonisateur comporte en outre un deuxième étage amplificateur à gain commandé connecté en aval des moyens de filtrage en bande de base. Le synthonisateur comprend alors également :

- des deuxièmes moyens de calcul, connectés à la sortie des moyens de filtrage en bande de base, aptes à calculer dans la phase de fonctionnement normal la puissance moyenne du canal sélectionné,
- des deuxièmes moyens de comparaison, incorporés dans le bloc numérique, aptes à comparer cette puissance moyenne de canal calculée avec une deuxième valeur de référence prédéterminée correspondant à une puissance de canal maximale souhaitée à l'entrée de l'étage de conversion analogique/numérique, et
- des deuxièmes moyens de réglage aptes à régler le gain du deuxième étage amplificateur jusqu'à minimiser l'écart entre la puissance de canal calculée et ladite deuxième valeur de référence.

Préférentiellement, les moyens d'aiguillage du signal sont disposés entre la sortie du premier étage atténuateur/amplificateur et l'entrée de l'étage de transposition de fréquence.

Le bloc numérique peut incorporer les premiers moyens de calcul.

Le dispositif selon l'invention est avantageusement entièrement réalisé de façon intégrée sur un substrat semiconducteur.

L'invention propose également un récepteur de signaux de télévision numérique par satellite, comprenant un dispositif de synthonisation tel que celui défini ci-avant.

D'autres avantages et caractéristiques de l'invention apparaîtront à l'examen de la description détaillée de modes de réalisation et de mise en oeuvre, nullement limitatifs, et des dessins annexés, sur lesquels :

- la figure 1 est un synoptique schématique de l'architecture interne d'un dispositif de synthonisation de fréquence selon l'invention; et
- la figure 2 est un organigramme schématique des principales étapes d'un procédé de commande selon l'invention.

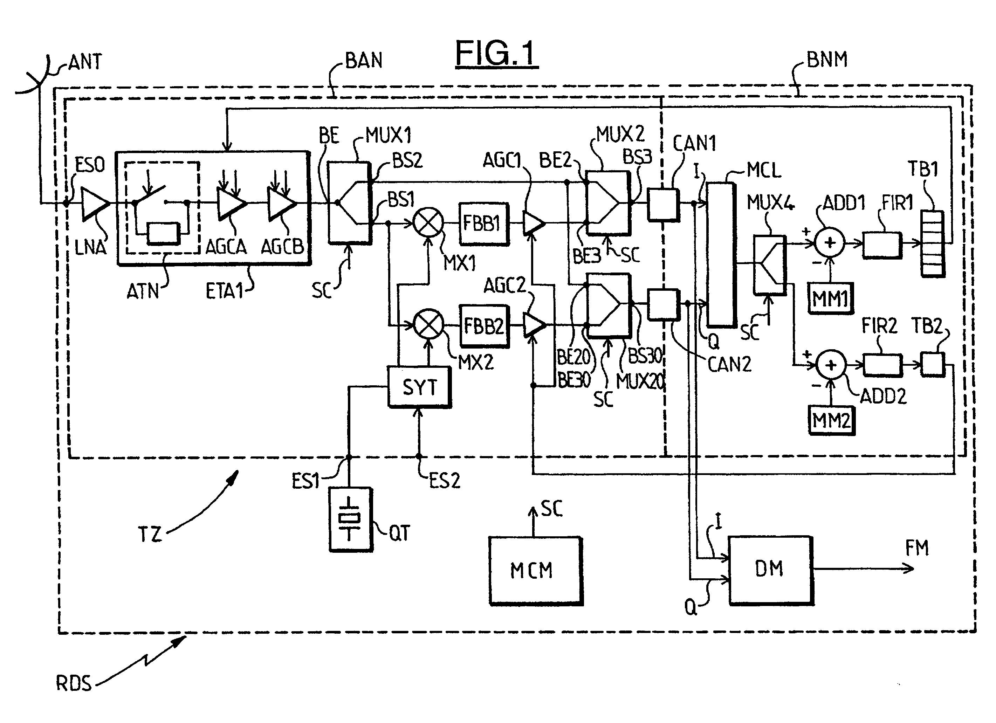

Sur la figure 1, la référence RDS désigne un récepteur/décodeur satellite ("Set-top box" en langue anglaise) connecté à une antenne parabolique ANT captant des signaux de télévision numérique, et destiné à recevoir et à décoder ces signaux.

Ce récepteur RDS comporte en tête, un dispositif de synthonisation, ou "tuner", TZ destiné à sélectionner le canal désiré parmi l'ensemble des canaux présents dans le signal reçu à l'entrée de signal ES0 de ce tuner.

Ce tuner TZ, entièrement réalisé de façon intégrée en technologie CMOS sur substrat de silicium, est du type à fréquence intermédiaire nulle, c'est-à-dire qu'il n'effectue pas de transposition de fréquences à une fréquence intermédiaire mais ne comporte qu'un seul étage de transposition de fréquence, comportant ici les mélangeurs MX1 et MX2, et transposant directement le signal au voisinage de la bande de base d'un canal. En d'autres termes, l'étage de transposition de fréquence délivre directement le canal sélectionné ainsi que les canaux immédiatement adjacents.

Le tuner TZ comporte en tête, un amplificateur faible bruit LNA connecté à l'entrée de signal ES0 et ayant par exemple un gain de 15 dB. L'amplificateur LNA est suivi d'un premier étage ETA1 atténuateur/amplificateur à gain commandé. Plus précisément, cet étage ETA1 comporte un bloc atténuateur ATN commandable, que l'on a représenté schématiquement sur la figure 1 par un interrupteur shuntant ou non l'atténuateur proprement dit. Cet atténuateur permet, lorsqu'il est actionné, une atténuation de signal de -20 dB par exemple.

L'étage ETA1 comporte également, à la suite de ce bloc atténuateur ATN, deux amplificateurs à gain commandé AGCA et AGCB . Le gain de chaque amplificateur AGCA ou AGCB peut être réglé, par exemple entre trois valeurs discrètes, à savoir les valeurs 0 dB, 6 dB et 12 dB, par exemple. Le gain total du bloc amplificateur composé des deux amplificateurs AGCA et AGCD, peut donc être commandé de façon à prendre les valeurs 0 dB, 6 dB, 12 dB, 18 dB ou 24 dB.

La sortie de l'étage ETA1 est connectée à la borne d'entrée BE d'un moyen d'aiguillage de signal formé ici d'un multiplexeur MUX1 commandé par un signal de commande SC. Ce multiplexeur MUX1 comporte une première borne de sortie BS1 reliée aux deux mélangeurs MX1 et MX2 de l'étage de transposition de fréquence.

Ces deux mélangeurs MX1 et MX2 reçoivent par ailleurs, de façon classique, deux signaux de mélange en quadrature issus par exemple d'un synthétiseur de fréquence SYT. La fréquence de chacun des deux signaux de mélange est identique et correspond à la fréquence du canal sélectionné. Le synthétiseur de fréquence SYT est commandé par un signal de sélection émanant d'une entrée de sélection ES2 connectée à un bus $I^2C$ selon une dénomination connue de l'homme du métier. Par ailleurs, le synthétiseur de fréquence est piloté par un signal d'horloge de référence reçu sur une entrée ES1 et provenant d'un quartz QT.

Les deux voies de traitement, connectées aux sorties des deux mélangeurs MX1 et MX2 sont des voies en quadrature, respectivement dénommées I et Q selon une dénomination usuelle connue de l'homme du métier. La voie I représente le signal en phase, tandis que la voie Q représente le signal en quadrature.

Les mélangeurs MX1 et MX2 sont équipés en sortie de filtres passe-bas, dont la fréquence de coupure est de l'ordre de 150 à 250 MHz. Le signal de sortie des deux mélangeurs MX1 et MX2 est donc un signal centré autour de la fréquence 0 MHz, s'étendant sur une bande de fréquence de 150 à 250 MHz et comportant le canal sélectionné ainsi que les canaux immédiatement adjacents. La largeur d'un canal étant de l'ordre de 40 MHz pour des signaux de télévision numérique haute définition, les deux filtres en bande de base FBB1 et FBB2, qui suivent les deux mélangeurs MX1 et MX2 ont une bande passante de l'ordre de 40 MHz. En conséquence, on retrouve en sortie de ces deux filtres en bande de base un signal filtré comportant uniquement le canal sélectionné.

Les deux filtres en bande de base sont suivis d'un deuxième étage d'amplification à gain commandé formé ici de deux amplificateurs à gain commandé AGC1 et AGC2. Les sorties des deux amplificateurs AGC1 et AGC2 sont respectivement connectées aux bornes d'entrée BE3 et BE30 de deux autres multiplexeurs MUX2 et MUX20 également commandés par le signal de commande SC.

Le multiplexeur MUX1 comporte également une deuxième borne de sortie BS2 directement connectée aux deux autres bornes d'entrée BE2 et BE20 des deux autres multiplexeurs MUX2 et MUX20. Cette voie de connexion directe shunte donc tout moyen de filtrage du signal global, en l'espèce les filtres présents à l'entrée des mélangeurs MX1 et MX2 ainsi que les filtres en bande de base FBB1 et FBB2. Cette connexion directe va permettre, comme on le verra plus en détail ci-après, de calculer la puissance globale de l'intégralité du signal reçu.

Les deux bornes de sortie BS3 et BS30 de deux multiplexeurs MUX2 et MUX20 sont respectivement connectées aux deux entrées de deux convertisseurs analogiques numériques CAN1 et CAN2 destinés à échantillonner les signaux analogiques reçus à leur entrée à une fréquence d'échantillonnage, par exemple de l'ordre de 150 MHz. Ces deux convertisseurs analogiques/numériques CAN1 et CAN2 marquent la frontière entre le bloc analogique BAN du tuner BZ et le bloc numérique BNM de ce tuner.

Les deux signaux numériques en quadrature I et Q délivrés par les convertisseurs analogiques numériques sont traités dans un bloc de calcul MCL qui va déterminer la puissance de ce signal (I, Q) en en calculant par exemple le module. Une façon simplifiée de calculer le module du signal dans le bloc MCL est fournie par la formule (1) ci-dessous :

$$\text{Module (I, Q)} = \text{Max (abs (I), abs (Q))} + 1/2 \text{ Min (abs (I), abs (Q))} \qquad (1)$$

Dans cette formule, Max désigne la valeur maximale, Min désigne la valeur minimale et abs désigne la valeur absolue.

Comme on le verra plus en détail ci-après, selon les phases de fonctionnement du tuner, la borne d'entrée du multiplexeur MUX1 peut être connectée soit sur sa première borne de sortie BS1, soit sur sa deuxième borne de sortie BS2. De même, les bornes de sortie BS3 et BS30 des multiplexeurs MUX2 et MUX20 peuvent être corrélativement reliées aux bornes de sortie BE2 et BE20 ou BE3 et BE30. Lorsqu'une connexion directe est effectuée entre la sortie de l'étage ETA1 et les convertisseurs analogiques numériques CAN1 et CAN2, les deux signaux I et Q sont en fait des signaux identiques et non en quadrature. La formule (1) ci-dessus du calcul du module se simplifie donc et devient la formule (2) ci-dessous dans laquelle S désigne le signal délivré par la borne de sortie BS2 du multiplexeur MUX1.

$$\text{Module (S)} = \text{Max (abs (S))} + 1/2 \text{ Min (abs (S))} \qquad (2)$$

Par contre, lorsque la sortie de l'étage ETA1 est connectée au convertisseur CAN1 et CAN2 par l'intermédiaire de l'étage de transposition de fréquence et des filtres en bande de base, les deux signaux I et Q sont bien deux signaux en quadrature.

La sortie du bloc de calcul MCL est reliée à un multiplexeur MUX4 dont l'une des sorties est reliée à un soustracteur ADD1 et dont l'autre sortie est reliée à un soustracteur ADD2.

Lorsque l'on souhaite calculer la puissance globale moyenne de l'intégralité du signal reçu, le multiplexeur MUX4 est commandé de façon à délivrer le signal issu du bloc de calcul MCL au soustracteur ADD1. Ce soustracteur ADD 1 reçoit par ailleurs sur sa deuxième entrée une première valeur de référence, stockée par exemple dans un registre ou une mémoire MM1. Cette première valeur de référence correspond à une puissance maximale souhaitée en un endroit prédéterminé du bloc analogique, par exemple à l'entrée des mélangeurs de l'étage de transposition de fréquence. A titre indicatif, on pourra par exemple fixer cette première valeur de référence à -10 dBm, ce qui permet d'éviter ainsi une saturation des éléments du bloc analogique.

Chaque échantillon délivré par le bloc de calcul MCL est représentatif en fait de la puissance instantanée du signal reçu à l'entrée de ce bloc MCL. Le soustracteur ADD1 compare en fait la puissance instantanée de chaque échantillon avec la première valeur de référence. Ces valeurs de comparaison successives sont ensuite temporellement intégrées dans un intégrateur à coefficients programmables FIR1.

A titre indicatif, l'intégration est effectuée sur une fenêtre glissante de $2^{21}$ échantillons et la sortie de l'intégrateur fournit donc l'écart entre la puissance globale moyenne de l'intégralité du signal reçu et la première valeur de référence. Ceci étant, il serait également possible d'effectuer l'intégration en sortie du bloc MCL afin de calculer la puissance moyenne du signal global, puis de soustraire de cette valeur moyenne la valeur de référence. Le soustracteur serait dans ce cas disposé en aval de l'intégrateur.

La sortie de l'intégrateur FIR1 est ensuite délivrée à des moyens de réglage du gain de l'étage ETA1. Ces moyens de réglage comportent par exemple une table de référence qui est décodée par la sortie de l'intégrateur et qui va délivrer un mot numérique dont la valeur va permettre de commander l'interrupteur du bloc atténuateur ATN et de fixer les gains des deux amplificateurs AGCA et AGCB.

Lorsque l'entrée du multiplexeur MUX4 est connectée sur son autre sortie, c'est-à-dire celle reliée au soustracteur ADD2, il va être possible de calculer la puissance moyenne du canal sélectionné et de régler le gain des deux amplificateurs à gain commandé AGC1 et AGC2. A cet égard, un registre ou mémoire MM2 contient une deuxième valeur de référence correspondant à une puissance de canal maximale souhaitée à l'entrée de l'étage de conversion analogique/numérique de façon à obtenir le maximum de dynamique à l'entrée de cet étage. A titre indicatif, cette deuxième valeur de référence peut être prise égale à 7 dB. Le soustracteur ADD2 calcule alors l'écart entre la puissance instantanée de chaque échantillon du canal sélectionné et cette deuxième valeur de référence. Ces écarts sont ensuite intégrés dans un intégrateur FIR2 ayant une structure analogue à celle décrite pour l'intégrateur FIR1. Dé même, par analogie à ce qui a été décrit ci-avant pour l'intégrateur FIR1, l'intégrateur FIR2 décode une deuxième table de référence TB2 qui permet de régler le gain des amplificateurs AGC1 et AGC2.

Le tuner TZ comporte par ailleurs des moyens de commande MCM, par exemple réalisés de façon câblée ou bien au sein d'un microcontrôleur et destinés à délivrer notamment le signal de commande SC permettant de commuter les différents multiplexeurs du tuner.

Enfin, de façon classique, le récepteur RDS comporte un bloc DM recevant les deux signaux I et Q et capable d'effectuer les traitements classiques ultérieurs de démodulation (tels qu'une démodulation QPSK ou 8 PSK selon une dénomination bien connue de l'homme du métier) et de décodage de canal tels qu'un décodage de Viterbi, un désentrelacement, un décodage de Reed-Solomon, un débrassage, de façon à délivrer un flux de paquets FM qui seront décodés dans un bloc de décodage de source conforme à la norme MPEG, par exemple.

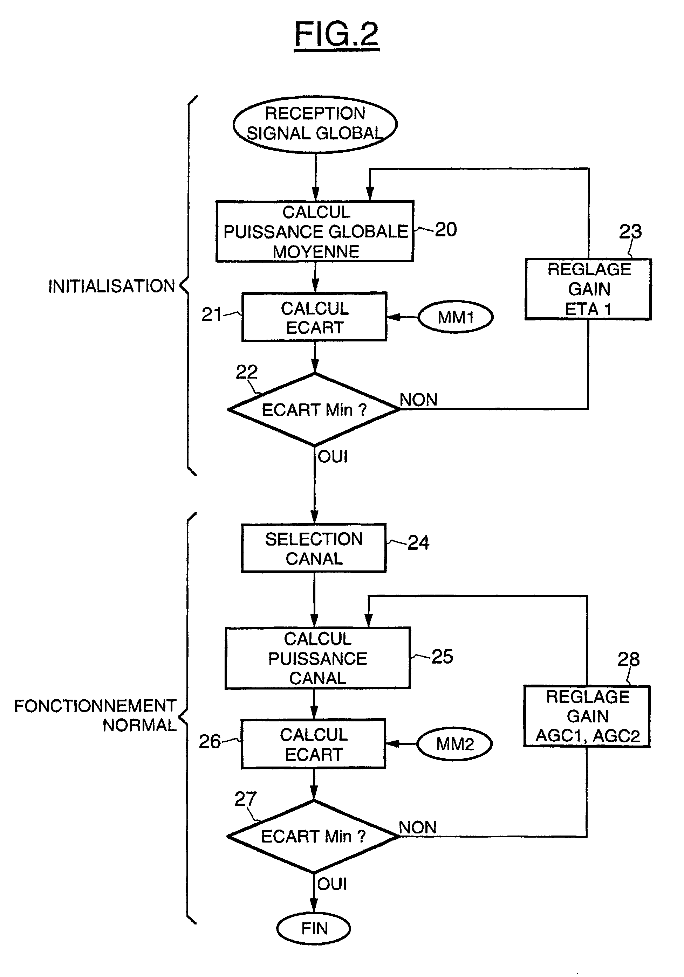

On va maintenant décrire plus en détail le fonctionnement du tuner selon l'invention, en se référant plus particulièrement à la figure 2.

A la mise en marche du tuner, ou lors d'un changement de canal, les moyens de commande MCM positionnent les multiplexeurs MUX1, MUX2 et MUX20 de façon à permettre une connexion directe entre la sortie de l'étage d'amplification ETA1 et les convertisseurs analogique/numérique. De même, le multiplexeur MUX4 est positionné de façon à relier le bloc MCL à l'additionneur ADD1.

Une phase d'initialisation du tuner débute alors. Au début de cette phase d'initialisation, l'interrupteur du bloc atténuateur ATN est ouvert par défaut, activant l'atténuateur proprement dit et les gains des amplificateurs AGCA et AGCB sont par défaut fixés à zéro. L'intégralité du signal reçu à l'entrée du signal ES0 est amplifiée dans l'amplificateur LNA, puis atténuée dans l'étage ETA1 et convertie ensuite dans les convertisseurs analogique/numérique CAN1 et CAN2. La puissance globale moyenne du signal est ensuite déterminée comme expliqué ci-avant et la sortie du filtre FIR1, représentatif de l'écart entre cette puissance globale moyenne et la valeur de référence contenue dans le registre MM1, décode la table TB1, ce qui provoque le réajustement du gain de l'étage ETA1. (Etapes 20, 21 et 23). En fait, le réajustement ne s'effectue que si l'écart entre cette puissance globale moyenne et la valeur de référence contenue dans le registre MM1 peut être minimisé (étape 22), compte tenu des possibilités d'ajustement du gain fournies par l'étage ETA1.

Plus précisément, à titre d'exemple, si l'on suppose que la puissance du signal reçu à l'entrée ES0 est égale à -5 dBm, la puissance du signal après amplification dans l'amplificateur LNA ayant un gain de 15 dB, est égale à +10 dBm. Après passage dans l'atténuateur ATN et dans les amplificateurs AGCA et AGCB réglés initialement avec un gain nul, la puissance globale moyenne du signal à la sortie de l'étage ETA1 est égale à - 10 dBm. Cette puissance sera calculée dans le bloc numérique et comparée à la première valeur de référence qui est justement égale à -10 dBm. Dans ce cas, l'écart est nul et par conséquent minimal. La phase d'initialisation se termine alors et les commandes de gain et d'atténuation de l'étage ETA1 ne sont pas alors modifiées.

Si, par contre, la puissance du signal reçu à l'entrée ES0 est égale à -20 dBm, la puissance du signal à la sortie de l'étage ETA1 est égale à -25 dBm. L'écart calculé entre cette puissance globale moyenne et la première valeur de référence est alors égal à -15 dBm. Dans ce cas, les moyens de réglage du gain de l'étage ETA1 peuvent par exemple directement régler les gains des deux amplificateurs AGCA de façon à conférer un gain total de 12 dB, ce qui va conduire à l'obtention d'une puissance de signal en sortie de l'étage ETA1 égale à -13 dBm. Compte tenu des possibilités de réglage par palier des amplificateurs AGCA et AGCB, l'écart de -3 dB entre cette valeur et la première valeur de référence est considéré comme l'écart minimal. La phase d'initialisation est par conséquent terminée.

En variante, il aura été possible d'effectuer deux cycles de réglage successifs en augmentant deux fois de suite par pas de 6 dB, le gain de l'étage ETA1.

A la fin de la phase d'initialisation, le tuner rentre dans une phase de fonctionnement normal, dans laquelle les moyens de commande MCM délivrent un signal de commande SC positionnant les multiplexeurs sur leur autre voie. Au cours de cette phase de fonctionnement normal, on sélectionne le canal désiré (étape 24) et la puissance de canal est calculée d'une façon analogue à celle qui a été décrite ci-avant dans le bloc MCL (étape 25), puis comparée et moyennée à l'aide du soustracteur ADD2, de l'intégrateur FIR2 et de la deuxième valeur de référence stockée dans la mémoire MM2 (étape 26). Le décodage de la table TB2 permet le réglage plus fin des amplificateurs AGC1 et AGC2. Il convient de noter ici que, alors que dans cette phase de fonctionnement normal, le gain de l'étage ETA1 est figé, le gain des amplificateurs AGC1 et AGC2 est constamment réajusté (étape 28) tant que l'écart calculé n'est pas considéré comme minimal (étape 27).

L'nvention n'est pas limitée aux modes de réalisation et de mise en oeuvre décrits ci-avant mais en embrasse toutes les variantes. Ainsi, l'étage ETA1, bien que dénommé d'une façon générale "étage atténuateur/amplificateur", pourrait être exempt d'atténuateur.

**Revendications**

**1.** Procédé de commande d'un synthonisateur du type à fréquence intermédiaire nulle, comprenant un bloc analogique (BAN) comportant un premier étage atténuateur/amplificateur à gain commandé connecté en amont d'un étage de transposition de fréquence comportant des moyens de filtrage en bande de base, et un bloc numérique (BNM) connecté au bloc analogique par un étage de conversion analogique/numérique, **caractérisé par le fait qu'**il comprend une phase d'initialisation dans laquelle on calcule (20) la puissance globale moyenne de l'intégralité du signal reçu par le synthonisateur, on compare dans le bloc numérique cette puissance globale calculée avec une première valeur de référence prédéterminée correspondant à une puissance maximale souhaitée en un endroit prédéterminé du bloc analogique et on règle le gain du premier étage atténuateur/amplificateur (ETA1) jusqu'à minimiser l'écart entre la puissance globale calculée et ladite valeur de référence, et une phase de fonctionnement normal dans laquelle, le gain du premier étage atténuateur/amplificateur étant figé, on sélectionne (24) l'un des canaux du signal reçu.

**2.** Procédé selon la revendication 1,**caractérisé par le fait que**, le bloc analogique du synthonisateur comportant en outre un deuxième étage amplificateur à gain commandé (AGC1, AGC2) connecté en aval des moyens de filtrage en bande de base, on calcule (25) dans la phase de fonctionnement normal la puissance moyenne du canal sélectionné, on compare dans le bloc numérique cette puissance moyenne de canal calculée avec une deuxième valeur de référence prédéterminée correspondant à une puissance de canal maximale souhaitée à l'entrée de l'étage de conversion analogique/numérique et on règle le gain du deuxième étage amplificateur jusqu'à minimiser l'écart entre la puissance de canal calculée et ladite deuxième valeur de référence.

**3.** Procédé selon la revendication 1 ou 2, **caractérisé par le fait qu'**on calcule la puissance globale moyenne de l'intégralité du signal reçu par le synthonisateur à partir du signal disponible entre la sortie du premier étage atténuateur/amplificateur (ETA1) et l'entrée de l'étage de transposition de fréquence (MX1, MX2).

**4.** Procédé selon la revendication 1, 2 ou 3, **caractérisé par le fait que** le calcul de la puissance globale moyenne de l'intégralité du signal reçu est effectuée dans le bloc numérique (BNM).

**5.** Dispositif de synthonisation du type à fréquence intermédiaire nulle comprenant une entrée de signal (ESO), un bloc analogique (BAN) comportant un premier étage atténuateur/amplificateur à gain commandé (ETA1) connecté entre l'entrée de signal et un étage de transposition de fréquence comportant des moyens de filtrage en bande de base, et un bloc numérique (BNM) connecté au bloc analogique par un étage de conversion analogique/numérique, **caractérisé par le fait qu'**il comprend

un moyen commandable d'aiguillage de signal (MUX1), incorporé dans le bloc analogique, possédant une borne d'entrée (BE) connectée à l'entrée de signal, une première borne de sortie (BS1) connectée à l'entrée des moyens de filtrage en bande de base (FBB1, FBB2), une deuxième borne de sortie (BS2) connectée directement à l'entrée de l'étage de conversion analogique/numérique (CAN1, CAN2),
des premiers moyens de calcul (MCL, FIR1), connectés à la deuxième borne de sortie du moyen d'aiguillage, aptes à calculer la puissance globale moyenne de l'intégralité du signal reçu par le synthonisateur,
des premiers moyens de comparaison (ADD1), incorporés dans le bloc numérique, aptes à comparer cette puissance globale calculée avec une première valeur de référence prédéterminée correspondant à une puissance maximale souhaitée en un endroit prédéterminé du bloc analogique,
des premiers moyens de réglage (TB1) aptes à régler le gain du premier étage atténuateur/amplificateur en fonction du résultat de ladite comparaison, et
des moyens de commande (MCM) aptes dans une phase d'initialisation, à commander les moyens d'aiguillage de façon à connecter leur borne d'entrée et leur deuxième borne de sortie, jusqu'à minimiser l'écart entre la puissance globale calculée et ladite première valeur de référence, et dans une phase de fonctionnement normal au cours de laquelle un canal du signal reçu est sélectionné, à commander les moyens d'aiguillage de façon à connecter leur borne d'entrée et leur première borne de sortie, le gain du premier étage atténuateur/ amplificateur étant figé.

**6.** Dispositif selon la revendication 5, **caractérisé par le fait que** le bloc analogique du synthonisateur comporte en outre un deuxième étage amplificateur à gain commandé (AGC1, AGC2) connecté en aval des moyens de filtrage en bande de base, **par le fait que** le synthonisateur comprend également

des deuxièmes moyens de calcul (MCL), connectés à la sortie des moyens de filtrage en bande de base (FBB1, FBB2), aptes à calculer dans la phase de fonctionnement normal la puissance moyenne du canal sélectionné,
des deuxièmes moyens de comparaison (ADD2), incorporés dans le bloc numérique, aptes à comparer cette puissance moyenne de canal calculée avec une deuxième valeur de référence prédéterminée correspondant à une puissance de canal maximale souhaitée à l'entrée de l'étage de conversion analogique/numérique, et
des deuxièmes moyens de réglage (TB2) aptes à régler le gain du deuxième étage amplificateur jusqu'à minimiser l'écart entre la puissance de canal calculée et ladite deuxième valeur de référence.

**7.** Dispositif selon la revendication 5 ou 6, **caractérisé par le fait que** les moyens d'aiguillage du signal (MUX1) sont disposés entre la sortie du premier étage atténuateur/amplificateur (ETA1) et l'entrée de l'étage de transposition de fréquence (MX1, MX2).

**8.** Dispositif selon la revendication 5, 6 ou 7, **caractérisé par le fait que** le bloc numérique incorpore les premiers moyens de calcul (MCL).

**9.** Dispositif selon l'une des revendications 5 à 7, **caractérisé par le fait qu'**il est entièrement réalisé de façon intégré sur un substrat semiconducteur.

**10.** Récepteur de signaux de télévision numériques par satellite, **caractérisé par le fait qu'**il comprend un dispositif de synthonisation (TZ) tel que défini dans l'une des revendications 5 à 9.

**Claims**

**1.** Process for controlling a tuner of the type having zero intermediate frequency, comprising an analogue block (BAN) containing a first attenuator/controlled-gain amplifier stage connected upstream of a frequency transposition stage containing baseband filtering means, and a digital block (BNM) connected to the analogue block by an analogue/digital conversion stage, **characterized in that** it comprises a phase of initialization in which the overall mean power of the entire signal received by the tuner is calculated (20), this overall calculated power is compared in the digital block with a first predetermined reference value corresponding to a maximum power desired at a predetermined location of the analogue block and the gain of the first attenuator/amplifier stage (ETA1) is adjusted so as to minimize the deviation between the overall calculated power and the said reference value, and a phase of normal operation in which, the gain of the first attenuator/amplifier stage being fixed, one of the channels of the signal received is selected (24).

2. Process according to Claim 1, **characterized in that**, the analogue block of the tuner furthermore containing a second controlled-gain amplifier stage (AGC1, AGC2) connected downstream of the baseband filtering means, the mean power of the selected channel is calculated (25) in the phase of normal operation, this calculated mean channel power is compared in the digital block with a second predetermined reference value corresponding to a maximum channel power desired at the input of the analogue/digital conversion stage and the gain of the second amplifier stage is adjusted so as to minimize the deviation between the calculated channel power and the said second reference value.

3. Process according to Claim 1 or 2, **characterized in that** the overall mean power of the entire signal received by the tuner is calculated on the basis of the signal available between the output of the first attenuator/amplifier stage (ETA1) and the input of the frequency transposition stage (MX1, MX2).

4. Process according to Claim 1, 2 or 3, **characterized in that** the calculation of the overall mean power of the entire signal received is performed in the digital block (BNM).

5. Tuning device of the type having zero intermediate frequency comprising a signal input (ESO), an analogue block (BAN) containing a first attenuator/controlled-gain amplifier stage (ETA1) connected between the signal input and a frequency transposition stage containing baseband filtering means, and a digital block (BNM) connected to the analogue block by an analogue/digital conversion stage, **characterized in that** it comprises

a controllable means of signal routing (MUX1), incorporated into the analogue block, possessing an input terminal (BE) connected to the signal input, a first output terminal (BS1) connected to the input of the baseband filtering means (FBB1, FBB2), a second output terminal (BS2) connected directly to the input of the analogue/digital conversion stage (CAN1, CAN2),

first means of calculation (MCL, FIR1), connected to the second output terminal of the routing means, and able to calculate the overall mean power of the entire signal received by the tuner,

first means of comparison (ADD1), incorporated into the digital block, and able to compare this overall calculated power with a first predetermined reference value corresponding to a maximum power desired at a predetermined location of the analogue block,

first means of adjustment (TB1) able to adjust the gain of the first attenuator/amplifier stage as a function of the result of the said comparison, and

means of control (MCM) able in a phase of initialization, to control the routing means in such a way as to connect their input terminal to their second output terminal, so as to minimize the deviation between the overall calculated power and the said first reference value, and in a phase of normal operation in the course of which a channel of the signal received is selected, to control the routing means in such a way as to connect their input terminal to their first output terminal, the gain of the first attenuator/amplifier stage being fixed.

6. Device according to Claim 5, **characterized in that** the analogue block of the tuner furthermore contains a second controlled-gain amplifier stage (AGC1, AGC2) connected downstream of the baseband filtering means, and **in that** the tuner also comprises

second means of calculation (MCL), connected to the output of the baseband filtering means (FBB1, FBB2), and able to calculate in the phase of normal operation the mean power of the selected channel,

second means of comparison (ADD2), incorporated into the digital block, and able to compare this mean calculated channel power with a second predetermined reference value corresponding to a maximum channel power desired at the input of the analogue/digital conversion stage, and

second means of adjustment (TB2) able to adjust the gain of the second amplifier stage so as to minimize the deviation between the calculated channel power and said second reference value.

7. Device according to Claim 5 or 6, **characterized in that** the signal routing means (MUX1) are disposed between the output of the first attenuator/amplifier stage (ETA1) and the input of the frequency transposition stage (MX1, MX2).

8. Device according to Claim 5, 6 or 7, **characterized in that** the digital block incorporates the first means of calculation (MCL).

9. Device according to one of Claims 5 to 7, **characterized in that** it is embodied entirely in integrated fashion on a semiconductor substrate.

10. Receiver of satellite digital television signals, **characterized in that** it comprises a tuning device (TZ) as defined in one of Claims 5 to 9.


**Patentansprüche**

1. Verfahren zur Steuerung eines Null-ZF-Tuner, der aufweist:

   einen analogen Block (BAN) mit einer ersten regelbaren Dämpfungs/Verstärkungsstufe, die vor einer Frequenzumsetzungsstufe mit Basisband-Filtereinrichtungen angeordnet ist, und
   einen digitalen Block (BNM), der über eine Analog/Digital-Wandlerstufe mit dem analogen Block verbunden ist,

   **dadurch gekennzeichnet, daß** es aufweist:

   eine Initialisierungsphase, in welcher die durchschnittliche Gesamtleistung des gesamten vom Tuner empfangenen Signals berechnet wird (20), im digitalen Block diese berechnete Gesamtleistung mit einem ersten vorgegebenen Referenzwert verglichen wird, der einer gewünschten maximalen Leistung an einem vorgegebenen Ort des anlogen Blocks entspricht, und der Verstärkungsfaktor der ersten Dämpfungs/Verstärkungsstufe (ETA1) geregelt wird, bis der Unterschied zwischen der berechneten Gesamtleistung und dem Referenzwert minimal ist, und
   eine normale Betriebsphase, in welcher einer der Kanäle des empfangenen Signals ausgewählt wird (24), wobei der Verstärkungsfaktor der ersten Dämpfungs/Verstärkungsstufe konstant gehalten wird.

2. Verfahren nach Anspruch 1, wobei der analoge Block des Tuner ferner eine zweite regelbare Verstärkerstufe (AGC1,AGC2) aufweist, die nach den Basisband-Filtereinrichtungen angeordnet ist, **dadurch gekennzeichnet, daß** in der normalen Betriebsphase die durchschnittliche Leistung des gewählten Kanals berechnet wird (25), im digitalen Block diese berechnete durchschnittliche Kanalleistung mit einem zweiten vorgegebenen Referenzwert verglichen wird, der einer gewünschten maximalen Kanalleistung am Eingang der Analog/Digital-Wandlerstufe entspricht und der Verstärkungsfaktor der zweiten Verstärkerstufe geregelt wird, bis der Unterschied zwischen der berechneten Kanalleistung und dem zweiten Referenzwert minimal ist.

3. Verfahren nach Anspruch 1 oder 2, **dadurch gekennzeichnet, daß** die durchschnittliche Gesamtleistung des gesamten vom Tuner empfangenen Signals ausgehend von dem zwischen dem Ausgang der ersten Dämpfungs/ Verstärkungsstufe (ETA1) und dem Eingang der Frequenzumsetzungsstufe (MX1,MX2) verfügbaren Signal berechnet wird.

4. Verfahren nach Anspruch 1, 2 oder 3, **dadurch gekennzeichnet, daß** die Berechnung der durchschnittlichen Gesamtleistung des gesamten empfangenen Signals im digitalen Block (BNM) ausgeführt wird.

5. Null-ZF-Tuner mit
   einem Signaleingang (ESO),
   einem analogen Block (BAN) mit einer ersten regelbaren Dämpfungs/Verstärkungsstufe (ETA1), die zwischen dem Signaleingang und einer Frequenzumsetzungsstufe mit Basisband-Filtereinrichtungen angeordnet ist, und
   einem digitalen Block (BNM), der über eine Analog/Digital-Wandlerstufe mit dem analogen Block verbunden ist,
   **dadurch gekennzeichnet, daß** er aufweist:

   eine im analogen Block eingebaute steuerbare Signalmultiplexereinrichtung, die einen mit dem Signaleingang verbundenen Eingangsanschluß, einen mit dem Eingang der Basisband-Filtereinrichtungen (FBB1,FBB2) verbundenen ersten Ausgangsanschluß (BS1), einen direkt mit dem Eingang der Analog/Digital-Wandlerstufe (CAN1,CAN2) verbundenen zweiten Ausgangsanschluß (BS2) besitzt,
mit dem zweiten Ausgangsanschluß der Multiplexereinrichtung verbundene Berechnungseinrichtungen (MCL, FIR1), die die durchschnittliche Gesamtleistung des gesamten vom Tuner empfangenen Signals berechnen können,
im digitalen Block eingebaute erste Vergleichseinrichtungen (ADD1), die diese berechnete Gesamtleistung mit einem ersten vorgegebenen Referenzwert vergleichen können, der einer gewünschten maximalen Leistung an einem vorgegebenen Ort des analogen Blocks entspricht,
erste Regeleinrichtungen (TB1), die den Verstärkungsfaktor der Dämpfungs/Verstärkungsstufe abhängig vom Ergebnis des Vergleichs regeln können, und
Steuereinrichtungen (MCM), die in einer Initialisierungsphase die Multiplexereinrichtungen so steuern können, um ihren Eingangsanschluß und ihren zweiten Ausgangsanschluß zu verbinden, bis der Unterschied zwischen der berechneten Gesamtleistung und dem ersten Referenzwert minimal ist, und die in einer normalen Betriebsphase, während welcher ein Kanal des empfangenen Signals ausgewählt wird, die Multiplexereinrichtungen so steuern können, um ihren Eingangsanschluß und ihren ersten Ausgangsanschluß zu verbinden, wobei der Verstärkungsfaktor der ersten Dämpfungs/Verstärkungsstufe konstant gehalten wird.

6. Vorrichtung nach Anspruch 5, **dadurch gekennzeichnet, daß** der analoge Block des Tuner ferner eine zweite regelbare Verstärkerstufe (AGC1,AGC2) aufweist, die nach den Basisband-Filtereinrichtungen angeordnet ist,
dadurch, daß der Tuner außerdem aufweist:

mit dem Ausgang der Basisband-Filtereinrichtungen (FBB1,FBB2) verbundene zweite Berechnungseinrichtungen (MCL), die in der normalen Betriebsphase die durchschnittliche Leistung des gewählten Kanals berechnen können,
im digitalen Block eingebaute zweite Vergleichseinrichtungen (ADD2), die diese berechnete durchschnittliche Kanalleistung mit einem zweiten vorgegebenen Referenzwert vergleichen können, der einer gewünschten maximalen Kanalleistung am Eingang der Analog/Digital-Wandlerstufe entspricht, und
zweite Regeleinrichtungen (TB2), die den Verstärkungsfaktor der zweiten Verstärkerstufe regeln können, bis der Unterschied zwischen der berechneten Kanalleistung und dem zweiten Referenzwert minimal ist.

7. Vorrichtung nach Anspruch 5 oder 6, **dadurch gekennzeichnet, daß** die Signalmultiplexereinrichtungen (MUX1) zwischen dem Ausgang der ersten Dämpfungs/Verstärkungsstufe (ETA1) und dem Eingang der Frequenzumsetzungsstufe (MX1,MX2) angeordnet sind.

8. Vorrichtung nach Anspruch 5, 6 oder 7, **dadurch gekennzeichnet, daß** der digitale Block die ersten Berechnungseinrichtungen (MCL) enthält.

9. Vorrichtung nach einem der Ansprüche 5 bis 7, **dadurch gekennzeichnet, daß** sie vollständig in integrierter Technik auf einem Halbleitersubstrat ausgeführt ist.

10. Empfänger für digitale Fernsehsignale über Satellit, **dadurch gekennzeichnet, daß** er eine Tuner-Vorrichtung (TZ), so wie in einem der Ansprüche 5 bis 9 definiert, aufweist.

## FIG.1

EP 1 152 526 B1

# FIG.2

RECEPTION
SIGNAL GLOBAL

CALCUL
PUISSANCE GLOBALE
MOYENNE — 20

REGLAGE
GAIN
ETA 1 — 23

INITIALISATION

21 — CALCUL
ECART ← MM1

22 — ECART Min ? — NON

OUI

SELECTION
CANAL — 24

CALCUL
PUISSANCE
CANAL — 25

REGLAGE
GAIN
AGC1, AGC2 — 28

FONCTIONNEMENT
NORMAL

26 — CALCUL
ECART ← MM2

27 — ECART Min ? — NON

OUI

FIN